# EUROPEAN PATENT APPLICATION

(11) **EP 2 302 111 A1**
(43) Date of publication of application: **30.03.2011**
(21) Application number: 09797795.3
(22) Date of filing: 26.06.2009
(51) Int. Cl.: C30B 29/38, C30B 23/06

(54) **PROCESS FOR PRODUCING GROUP III NITRIDE CRYSTAL AND GROUP III NITRIDE CRYSTAL**

(30) Priority: 17.07.2008 JP 2008186210; 19.05.2009 JP 2009121080
(71) Applicant: Sumitomo Electric Industries, Ltd., Chuo-ku Osaka-shi Osaka 541-0041 (JP)
(72) Inventor: MIYANAGA, Michimasa, Osaka-shi Osaka 554-0024 (JP); MIZUHARA, Naho, Itami-shi Hyogo 664-0016 (JP); TANIZAKI, Keisuke, Itami-shi Hyogo 664-0016 (JP); SATOH, Issei, Itami-shi Hyogo 664-0016 (JP); NAKAHATA, Hideaki, Itami-shi Hyogo 664-0016 (JP); ARAKAWA, Satoshi, Itami-shi Hyogo 664-0016 (JP); YAMAMOTO, Yoshiyuki, Itami-shi Hyogo 664-0016 (JP); SAKURADA, Takashi, Itami-shi Hyogo 664-0016 (JP)
(74) Representative: Grünecker, Kinkeldey, Stockmair & Schwanhäusser Anwaltssozietät
(86) International application number: PCT/JP2009/061699
(87) International publication number: WO 2010/007867

(57) **Abstract**

A method for producing a group III-nitride crystal having a large thickness and high quality and a group III-nitride crystal are provided. A method for producing a group III-nitride crystal 13 includes the following steps: A underlying substrate 11 having a major surface 11a tilted toward the <1-100> direction with respect to the (0001) plane is prepared. The group III-nitride crystal 13 is grown by vapor-phase epitaxy on the major surface 11a of the underlying substrate 11. The major surface 11a of the underlying substrate 11 is preferably a plane tilted at an angle of -5° to 5° from the {01-10} plane.

## Description

### Technical Field

The present invention relates to a method for producing a group III-nitride crystal and a group III-nitride crystal. For example, the present invention relates to a method for producing an aluminum nitride (AIN) crystal and an AIN crystal.

### Background Art

An AlN crystal has an energy band gap of 6.2 eV, a thermal conductivity of about 3.3 WK⁻¹cm⁻¹, and a high electrical resistance and thus has been receiving attention as a material for a substrate for optical devices and electronic devices.

For example, sublimation methods are employed as methods for growing a group III-nitride semiconductor crystal such as an AIN crystal. The sublimation methods include a method of growth with spontaneous nucleation without using a underlying substrate and a method of growth using a underlying substrate. In the growth with spontaneous nucleation, it is difficult to stably grow a large group III-nitride semiconductor crystal.

Examples of the method of growth using a underlying substrate are disclosed in, for example, U.S. Patent Nos. 5,858,086 (PTL 1), 6,296,956 (PTL 2), and 6,001,748 (PTL 3).

Each of PTLs 1 to 3 describes the implementation of the following steps: A raw material is placed in the bottom of a crucible. A underlying substrate, such as a SiC substrate, is arranged at the upper portion of the crucible so as to face the raw material. The raw material is heated to a temperature at which the raw material is sublimed. The raw material is sublimed by heating to form a sublimation gas, thereby growing an AIN crystal on a surface of the underlying substrate having a lower temperature than the raw material.

### Citation List

### Patent Literature

PTL 1: U.S. Patent No. 5,858,086
PTL 2: U.S. Patent No. 6,296,956
PTL 3: U.S. Patent No. 6,001,748

### Summary of Invention

### Technical Problem

In each of PTLs 2 and 3, the AIN crystal is grown at a growth rate of 0.5 mm/hr.

To achieve such a growth rate, it is necessary to heat the raw material to a high temperature. However, when the temperature of the raw material is high, the temperature of the underlying substrate is also high. Thus, a SiC substrate serving as the underlying substrate is degraded, disadvantageously failing to grow an AIN crystal with a sufficient thickness.

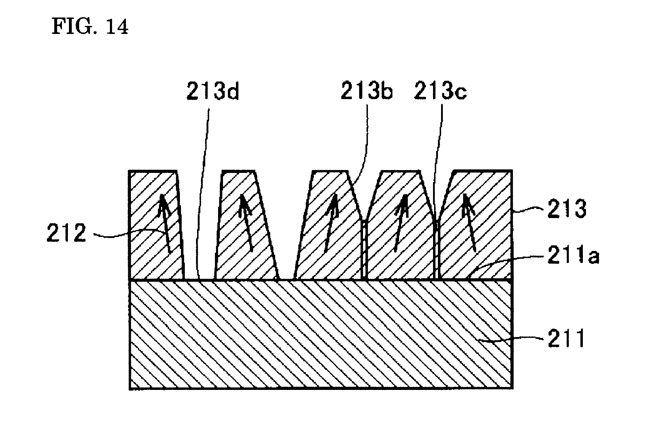

In PTL 1, the heating temperature of the raw material is as low as 1800°C. In the case where the temperature of the raw material is low, there are problems illustrated in Fig. 14. Figure 14 is a schematic cross-sectional view of a state in which an AIN crystal 213 is grown at a low temperature.

That is, as illustrated in Fig. 14, grains of AlN (crystal grains) are grown on a major surface 211 a of a underlying substrate 211. The grains have random orientations as indicated by arrows 212. Thus, a major surface 213a, which is a growth face, of the AIN crystal 213 is not uniform, and a recessed portion 213b is formed. Furthermore, a non-growth region 213d where the AIN crystal is not grown is present on the major surface 211a of the underlying substrate 211, in some cases. As described above, in the case where the recessed portion 213b and the non-growth region 213d are formed on the major surface 213a of the AIN crystal 213, when the AlN crystal is sliced parallel to the growth direction, a sufficient number of AlN substrates cannot be produced.

Moreover, as illustrated in Fig. 14, the random orientations of the grains are liable to cause a misorientation and a polycrystal. In particular, a defect 213c is disadvantageously liable to occur in the AIN crystal 213 under the recessed portion 213b, leading to poor crystallinity.

The present invention has been made in consideration of the foregoing problems. It is an object of the present invention to provide a method for producing a group III-nitride crystal with a large thickness and high quality, and to provide a high quality group III-nitride crystal with a large thickness.

### Solution to Problem

The inventors have conducted intensive studies and have found that, as illustrated in Fig. 14, the formation of the recessed portion 213b and the defect 213c when the AIN crystal 213 as a group III-nitride crystal is grown is attributed to the fact that the growth face of the AIN crystal 213 is the (0001) plane (c-plane). Furthermore, the inventors have made an intensive investigation of the cause of this and have found that the cause is attributed to the instability of the crystallinity of the c-plane of the group III-nitride crystal.

The inventors have conducted intensive studies to determine the factor for the foregoing instability and have found that when an AIN crystal is grown using the c-plane as a growth face, a plane equivalent to the (10-11) plane appears. The (10-11) plane is tilted toward the [10-10] direction with respect to the c-plane. The inventors have found that from the results, for group III-nitride crystals such as AIN crystals, the crystallinity of a plane tilted toward the <1-100> direction with respect to the (0001) plane is stable.

A method for producing a group III-nitride crystal according to the present invention includes the following steps: A underlying substrate having a major surface tilted toward the <1-100> direction with respect to the (0001) plane is prepared. The group III-nitride crystal is grown by vapor-phase epitaxy on the major surface of the underlying substrate.

In the method for producing a group III-nitride crystal according to the present invention, the group III-nitride crystal is grown on the major surface tilted toward the <1-100> direction with respect to the (0001) plane. The crystal orientation of the growth face of the group III-nitride crystal grown on the major surface of the underlying substrate inherits the crystal orientation of the major surface of the underlying substrate. Hence, the growth face of the group III-nitride crystal is a face having stable crystallinity, thus suppressing the formation of the growth face including randomly grown grains. That is, the group III-nitride crystal can be grown with the uniform growth face maintained. Therefore, even if the III-nitride crystal is grown at a low temperature, the crystal can be grown with high quality. Hence, the growth of the group III-nitride crystal at a low temperature results in the III-nitride crystal having high quality and a large thickness.

In the method for producing a group III-nitride crystal described above, the major surface of the underlying substrate is preferably a plane tilted at an angle of -5° to 5° from the {01-10} plane.

The inventors have found that a plane having very stable crystallinity of a III-nitride crystal is likely to be obtained on a major surface of a underlying substrate, the major surface being tilted at an angle of -5° to 5° from the {01-10} plane. It is thus possible to stably produce a high-quality group III-nitride crystal with a large thickness.

In the method for producing a III-nitride crystal according to the present invention, preferably, in the growth step, the group III-nitride crystal is grown at a temperature of 1600°C or more and less than 1950°C.

At 1600°C or higher, a raw material for the III-nitride crystal can be easily transformed into a vapor phase and fed onto the underlying substrate. Furthermore, at 1600°C or higher, the {01-10} plane is stable; hence, the group III-nitride crystal is obtained with higher quality. A temperature of 1900°C or less results in effective prevention of the degradation of the underlying substrate due to decomposition by vaporization, so that the III-nitride crystal can be grown so as to have a large thickness.

In the method for producing a group III-nitride crystal according to the present invention, preferably, in the preparation step, a SiC substrate is prepared as the underlying substrate.

The SiC substrate shows a small difference in lattice constant with the III-nitride crystal and high resistance to high temperatures. It is thus possible to more stably produce the high-quality group III-nitride crystal with a large thickness.

In the method for producing a III-nitride crystal according to the present invention, preferably, the preparation step includes a substep of preparing a group III-nitride crystal for the underlying substrate, the group III-nitride crystal having been grown in such a manner that the (0001) plane serves as a major surface, and a substep of cutting the group III-nitride crystal for the underlying substrate into the underlying substrate.

Thus, the group III-nitride crystal can be used as the underlying substrate. There is no or only a very small difference in lattice constant between the underlying substrate composed of the group III-nitride crystal and the group III-nitride crystal to be grown thereon. This makes it possible to stably produce the group III-nitride crystal having higher quality and a large thickness.

In the method for producing a group III-nitride crystal according to the present invention, preferably, in the growth step, the group III-nitride crystal is grown so as to have a thickness of 1 mm or more.

In the case where the group III-nitride crystal having a thickness of 1 mm or more is grown, the noticeable effect of the present invention described above is provided. Furthermore, a plurality of group III-nitride crystals can be produced from the grown group III-nitride crystal. Moreover, it is possible to reduce the cost of the plural group III-nitride crystals.

In the method for producing a group III-nitride crystal according to the present invention, preferably, the preparation step includes a substep of planarizing the major surface of the underlying substrate.

This makes it possible to suppress the formation of a plane other than the plane tilted toward the <1-100> direction with respect to the (0001) plane, on the major surface of the underlying substrate. It is thus possible to prepare the underlying substrate in which the plane tilted toward the <1-100> direction with respect to the (0001) plane is broadly formed on the major surface of the underlying substrate. It is therefore possible to reduce a region of the major surface in which a plane other than a stable plane is formed. This enables the high-quality group III-nitride crystal with a large thickness to be more stably produced.

Preferably, the method for producing a group III-nitride crystal according to the present invention further includes a step of cutting the group III-nitride crystal into a group III-nitride crystal with a nonpolar plane serving as the major surface.

The group III-nitride crystal has a large thickness with high quality, so that a plurality of group III-nitride crystals each having a nonpolar plane can be cut out. This makes it possible to produce the plural group III-nitride crystals each having the major surface of the nonpolar plane.

A group III-nitride crystal according to the present invention is a group III-nitride crystal produced by any one of the methods for producing a group III-nitride crystal described above. The group III-nitride crystal according to the present invention has a dislocation density of 5 × 10⁶ cm⁻² or less.

The group III-nitride crystal according to the present invention is produced by the method for producing a group III-nitride crystal described above. Thus, the formation of the growth face having random grains is suppressed, thereby resulting in the production of the group III-nitride crystal having a low dislocation density as described above. Advantageous Effects of Invention

According to the method for producing a group III-nitride crystal and the group III-nitride crystal according to the present invention, the group III-nitride crystal is grown on the major surface, which is a plane with stable crystallinity, tilted toward the <1-100> direction with respect to the (0001) plane, thereby resulting in the group III-nitride crystal having a large thickness and high quality.

### Brief Description of Drawings

[Fig. 1] Figure 1 is a schematic cross-sectional view of a group III-nitride crystal according to a first embodiment of the present invention.
[Fig. 2] Figure 2 is a flowchart of a method for producing a group III-nitride crystal according to the first embodiment of the present invention.
[Fig. 3] Figure 3 is a schematic cross-sectional view of a underlying substrate according to the first embodiment of the present invention.
[Fig. 4] Figure 4 is a schematic view of the crystal orientation of the underlying substrate according to the first embodiment of the present invention.
[Fig. 5] Figure 5 is a simplified schematic view of the crystal orientation illustrated in Fig. 4.
[Fig. 6] Figure 6 is a schematic cross-sectional view of a state in which a group III-nitride crystal according to the first embodiment of the present invention is grown.
[Fig. 7] Figure 7 is a schematic cross-sectional view of a state in which a group III-nitride crystal according to the first embodiment of the present invention is cut into a plurality of group III-nitride crystal slices.
[Fig. 8] Figure 8 is a flowchart of a method for producing a group III-nitride crystal according to a second embodiment of the present invention.
[Fig. 9] Figure 9 is a schematic cross-sectional view of a underlying substrate before planarization according to the second embodiment of the present invention.
[Fig. 10] Figure 10 is a flowchart of a method for producing a group III-nitride crystal according to a third embodiment of the present invention.
[Fig. 11] Figure 11 is a schematic cross-sectional view of a state of a grown group III-nitride crystal for a underlying substrate according to the third embodiment of the present invention.
[Fig. 12] Figure 12 is a schematic cross-sectional view of a state in which a underlying substrate according to the third embodiment of the present invention is cut out.
[Fig. 13] Figure 13 is a schematic view of a crystal growth apparatus used in examples.
[Fig. 14] Figure 14 is a schematic cross-sectional view of a state in which a AIN crystal is grown at a low temperature.

### Description of Embodiments

Embodiments of the present invention will be described below by way of the drawings. In the drawings, the same or equivalent portions are designated using the same reference signs, and descriptions are not redundantly repeated. Furthermore, in this specification, each individual direction is represented by [ ]. A collective direction is represented by < >. Each individual plane is represented by ( ). A collective plane is represented by { }. For a negative index, in crystallography, " " (bar) is supposed to be placed over a number. In this specification, a negative sign is placed before the number.

### (First Embodiment)

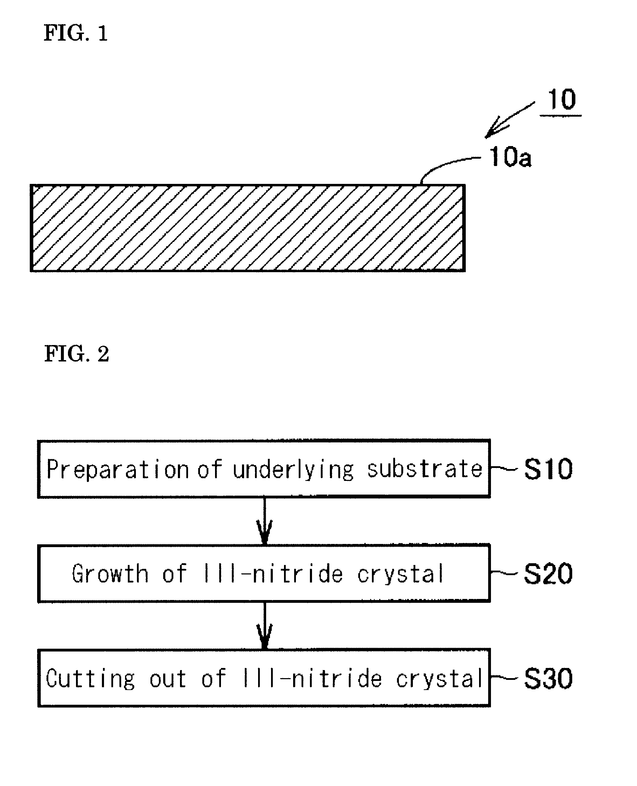

Figure 1 is a schematic cross-sectional view of a group III-nitride crystal according to this embodiment. A group III-nitride crystal 10 according to this embodiment will be described with reference to Fig. 1.

As illustrated in Fig. 1, the group III-nitride crystal 10 according to this embodiment has a major surface 10a. The major surface 10a is, for example, a nonpolar plane. Here, the term "nonpolar plane" indicates a plane orthogonal to a polar plane such as the c-plane. Examples of the nonpolar plane include the {1-100} plane (m-plane) and the {11-20} plane (a-plane).

The group III-nitride crystal 10 preferably has a dislocation density of 5 × 10⁶ cm⁻² or less and more preferably 5 × 10⁵ cm⁻² or less. In this case, when a device using the group III-nitride crystal 10 is fabricated, the device has improved characteristics. The dislocation density can be determined by, for example, a method in which the number of pits formed by etching in molten potassium hydroxide (KOH) is divided by a unit area.

The group III-nitride crystal 10 is, for example, an AlₓGa₍₁₋ₓ₎N (0 ≤ x ≤ 1) crystal and is preferably an AIN crystal.

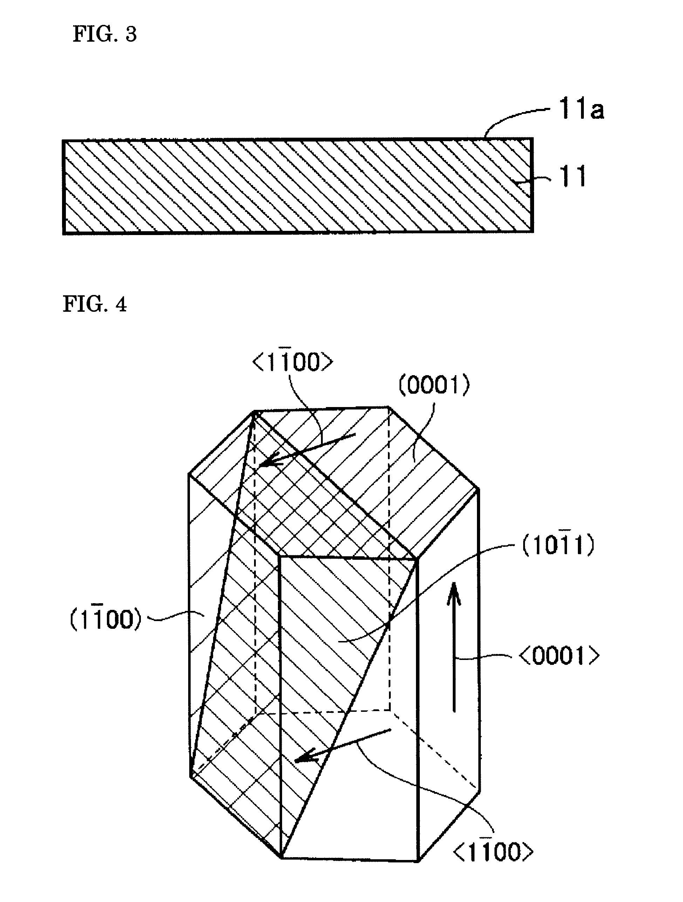

Figure 2 is a flowchart of a method for producing a group III-nitride crystal according to this embodiment. Subsequently, the method for producing the group III-nitride crystal 10 according to this embodiment will be described with reference to Fig. 3.

Figure 3 is a schematic cross-sectional view of a underlying substrate according to this embodiment. As illustrated in Figs. 2 and 3, first, a underlying substrate 11 having a major surface 11a tilted toward the <1-100> direction with respect to the (0001) plane is prepared (step S10). The major surface 11a of the underlying substrate 11 may have a region including a plane other than a plane tilted toward the <1-100> direction with respect to the (0001) plane. Preferably, the plane tilted toward the <1-100> direction with respect to the (0001) plane appears regularly in a large region. Highly preferably, the plane tilted toward the <1-100> direction with respect to the (0001) plane appears regularly in almost the entire region of the major surface 11a of the underlying substrate 11.

Note that the <1-100> direction includes the [1-100] direction, the [10-10] direction, the [-1100] direction, the [-1010] direction, the [01-10] direction, and the [0-110] direction.

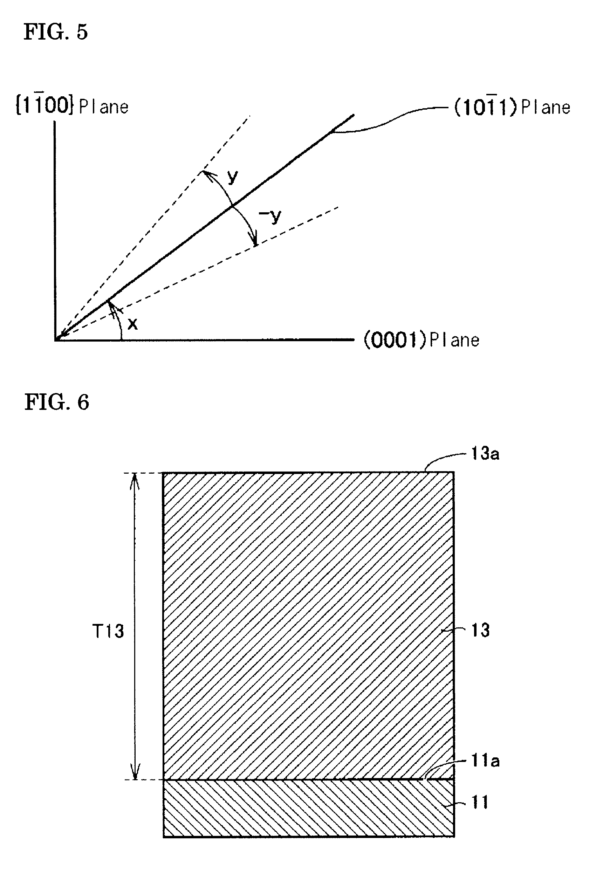

Figure 4 is a schematic view of the crystal orientation of the underlying substrate 11 according to this embodiment. Figure 5 is a simplified schematic view of the crystal orientation illustrated in Fig. 4. Here, the major surface 11a of the underlying substrate 11 will be described with reference to Figs. 4 and 5.

As illustrated in Figs. 4 and 5, the major surface 11a of the underlying substrate 11 is tilted toward the <1-100> direction with respect to the (0001) plane. In other words, the major surface 11a of the underlying substrate 11 is a plane in which the (0001) plane is tilted toward the {1-100} plane. Examples of the major surface 11a include the (10-11) plane (s-plane) as illustrated in Fig. 4.

The {1-100} plane includes the {1-100} plane, the {10-10} plane, the {-1100} plane, the {-1010} plane, the {01-10} plane, and the {0-110} plane.

The major surface 11a of the underlying substrate 11 is preferably tilted toward the <1-100> (m-axis) direction at an angle of 0.1° or more and less than 80° from the c-plane. In other words, as illustrated in Fig. 5, the major surface 11a preferably has a tilt angle x of 0.1° or more and less than 80° toward the {1-100} plane from the (0001) plane. In this case, the crystallinity is more stable. In particular, the major surface 11a of the underlying substrate 11 is preferably a plane tilted at an angle of -5° to 5° from the {01-10} plane and more preferably -0.5° to 0.5° from the {01-10} plane. In other words, as illustrated in Fig. 5, the major surface 11a preferably has a tilt angle y of -5° to 5° and more preferably -0.5° to 0.5° toward the {1-100} plane from the {01-10} plane, such as the (10-11) plane. In this case, the growth face of the group III-nitride crystal is more stable. In particular, the major surface 11a of the underlying substrate 11 is preferably located in the vicinity of the {10-11} plane. In this case, the growth face of the group III-nitride crystal is very stable.

The major surface 11a is not particularly limited so long as it is tilted toward the <1-100> direction with respect to the (0001) plane. The major surface 11a may be further tilted toward any direction other than the <1-100> direction. In the case where the major surface 11a is further tilted toward any direction other than the <1-100> direction, the major surface 11a preferably has a tilt angle of, for example, -5° to 5° toward any direction other than the <1-100> direction.

The underlying substrate 11 may be composed of a crystal having a composition the same as or different from that of a group III-nitride crystal to be grown. For example, SiC or sapphire may be used. The crystal system of the underlying substrate 11 is preferably hexagonal. A SiC substrate is composed of a material having a small difference in lattice constant with the group III-nitride crystal to be grown and having high resistance to high temperatures. In the case where the SiC substrate is used as the underlying substrate 11, 4H (hexagonal)-SiC (4 indicates the number of stacking layers in one period), 6H-SiC (6 indicates the number of stacking layers in one period), and so forth are preferably used compared with 3C (cubic)-SiC and so forth.

The major surface 11a of the underlying substrate 11 has a size of, for example, 2 inches or more. This makes it possible to grow a large-diameter group III-nitride crystal.

Figure 6 is a schematic cross-sectional view of a state in which a group III-nitride crystal is grown according to this embodiment. Next, as illustrated in Figs. 2 and 6, a group III-nitride crystal 13 is grown on the major surface 11a of the underlying substrate 11 by vapor-phase epitaxy (step S20).

The vapor-phase epitaxy is not particularly limited. For example, a sublimation method, hydride vapor phase epitaxy (HVPE), molecular beam epitaxy (MBE), and metal organic chemical vapor deposition (MOCVD) may be employed. In step S20, the sublimation method is preferably employed.

In growth step S20, a group III-nitride crystal is grown so as to preferably have a thickness T 13 of 1 mm or more and more preferably 5 mm or more. That is, in this embodiment, a group III-nitride bulk crystal is preferably grown. When a group II-nitride bulk crystal is grown, the noticeable effect of the present invention is provided, which is preferred. The upper limit of the thickness T13 is not particularly limited. For example, the upper limit is 50 mm or less from the viewpoint of easy production.

In growth step S20, the group III-nitride crystal 13 is preferably grown at a temperature of 1600°C or higher and less than 1950°C, more preferably 1600°C or higher and less than 1900°C, and still more preferably 1650°C or more and less than 1900°C. At 1600°C or higher, when the group III-nitride crystal 13 is grown by, for example, a sublimation method, a raw material can be easily sublimed. At 1650°C or higher, the raw material can be more easily sublimed. A growth temperature of less than 1950°C results in effective prevention of the degradation of the underlying substrate 11 due to decomposition by vaporization, so that the group III-nitride crystal 13 can be grown so as to have a larger thickness T13. A growth temperature of less than 1900°C results in more effective prevention of the degradation of the underlying substrate 11.

The growth temperature described above indicates the temperature of the underlying substrate 11 when the group III-nitride crystal 13 is grown by, for example, a sublimation method.

The growth face of the group III-nitride crystal 13 grown in step S20 inherits the crystal orientation of the major surface 11a of the underlying substrate 11. Thus, the group III-nitride crystal 13 has a major surface 13a tilted toward the <1-100> direction with respect to the (0001) plane.

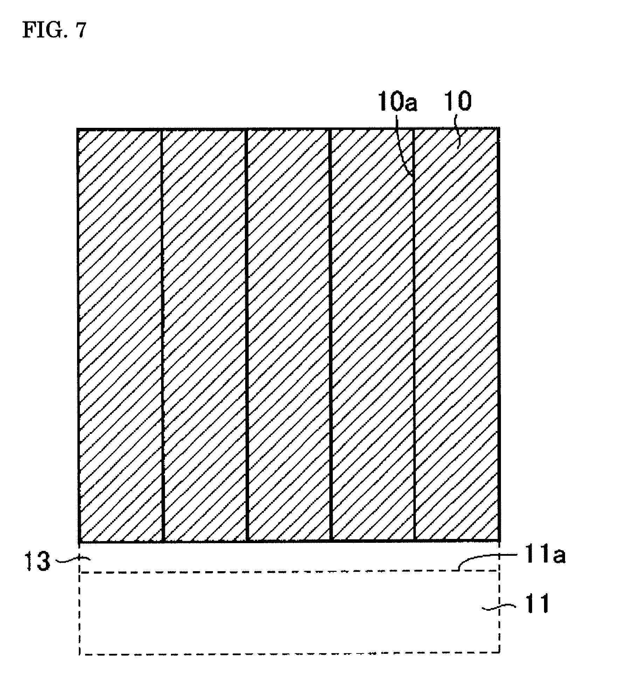

Figure 7 is a schematic cross-sectional view of a state in which the group III-nitride crystal 13 according to this embodiment is cut into a plurality of the group III-nitride crystals 10. Next, as illustrated in Figs. 2 and 7, the group III-nitride crystals 10 having the major surfaces 10a are cut out from the group III-nitride crystal 13 (step S30).

In step S30, the group III-nitride crystal 13 is preferably cut into crystals each having a nonpolar plane that serves as the major surface 10a. In this embodiment, the growth face (major surface 13a) of the group III-nitride crystal 13 is tilted toward the <1-100> direction with respect to the (0001) plane. Thus, in order to cut out the crystals each having a nonpolar plane that serves as the major surface 10a, the crystals are cut out in a direction intersecting (in Fig. 7, a direction orthogonal to) the major surface 11a of the underlying substrate 11.

A method of cutting out the crystals is not particularly limited. The group III-nitride crystal 13 can be divided by, for example, cutting or cleavage, into a plurality of group III-nitride crystals. The group III-nitride crystal 13 is a single crystal and thus can be easily divided. The term "cutting" indicates the mechanical cutting of the group III-nitride crystal 13 using, for example, a slicing machine equipped with an electroplated diamond wheel having an outer cutting blade. The term "cleavage" indicates the division of the group III-nitride crystal 13 along a crystal lattice plane.

Steps S10 to S30 described above are performed, thereby producing the group III-nitride crystal 10 illustrated in Fig. 1.

As described above, in the method for producing a group III-nitride crystal according to this embodiment, the group III-nitride crystal 13 is grown on the major surface 11a, which is tilted toward the <1-100> direction with respect to the (0001) plane, of the underlying substrate 11 (step S20). The crystal orientation of the growth face of the group III-nitride crystal 13 grown on the major surface 11a of the underlying substrate 11 inherits the crystal orientation of the major surface 11a of the underlying substrate 11. Hence, the growth face of the group III-nitride crystal 13 is a face having stable crystallinity, thus suppressing the formation of the growth face including random grains. Therefore, even if the group III-nitride crystal 13 is grown at a low temperature, the crystal can be grown with high quality. Hence, the growth of the group III-nitride crystal 13 at a low temperature results in the group III-nitride crystal 13 having high quality and a large thickness T13. In particular, in this embodiment, even when the group III-nitride crystal is grown at a low temperature, the resulting group III-nitride crystal has high quality. It is thus possible to stably produce the group III-nitride crystal 13 with good reproducibility.

The group III-nitride crystal 10 with high quality can be produced by cutting the group III-nitride crystal 13. The high-quality group III-nitride crystal 10 has a small dislocation density of, for example, 5 × 10⁶ cm⁻² or less.

The major surface 13a of the group III-nitride crystal 13 is in a state in which the formation of irregularities and so forth is suppressed, as compared with the major surface of a group III-nitride crystal formed on the (0001) plane. Thus, in the case where the group III-nitride crystals 10 are cut out from the group III-nitride crystal 13 as in this embodiment, a large number of the group III-nitride crystals 10 can be cut out, as compared with, for example, the case where the group III-nitride crystals 10 are cut out from a group III-nitride crystal formed on the (0001) plane. In the case where the same number of the group III-nitride crystals 10 are cut out, since the formation of a recessed portion is suppressed, a thickness of the group III-nitride crystal 13 to be grown is decreased. This results in a reduction in the production cost of the group III-nitride crystals 10.

Accordingly, the group III-nitride crystal 13 produced according to this embodiment may be used as a substrate for use in devices, for example, light emitting devices, such as light emitting diodes and laser diodes, rectifiers, electronic devices, such as bipolar transistors, field-effect transistors, and high electron mobility transistor (HEMT), semiconductor sensors, such as temperature sensors, pressure sensors, radiation sensors, and visible-ultraviolet photo detectors, surface acoustic wave devices (SAW devices), vibrators, oscillators, micro electro mechanical system (MEMS) components, and piezoelectric actuators.

### (Second Embodiment)

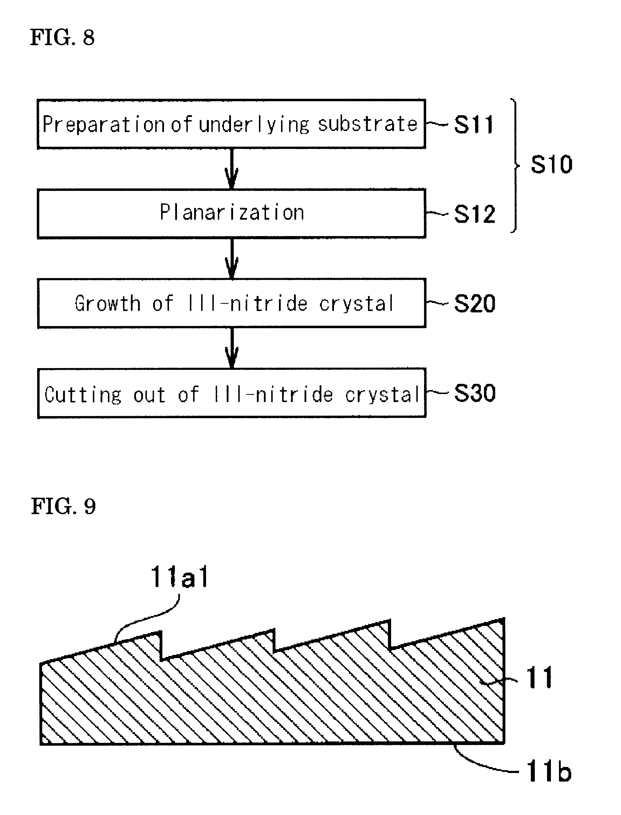

Figure 8 is a flowchart of a method for producing a group III-nitride crystal according to this embodiment. Referring to Fig. 8, the method for producing a group III-nitride crystal according to this embodiment basically includes the same steps as those in the method for producing a group III-nitride crystal according to the embodiment but is different in that step S10 of preparing the underlying substrate 11 includes substep S12 of planarizing the major surface 11a.

Figure 9 is a schematic cross-sectional view of a underlying substrate before planarization according to this embodiment. As illustrated in Figs. 8 and 9, first, the underlying substrate 11 having a major surface with irregularities is prepared (substep S11). Microscopic observation of the irregularities on the major surface shows that, for example, the c-plane appears in a region 11a1 tilted in Fig. 9.

Next, the major surface of the underlying substrate 11 is planarized (substep S 12). In substep S12, the region 11a1 illustrated in Fig. 9 is removed from the major surface of the underlying substrate 11 to allow a plane tilted toward the <1-100> direction with respect to the (0001) plane parallel to a back surface 11b to appear regularly in a large region.

A method of planarization is not particularly limited. The planarization may also be performed by, for example, thermal sublimation of the major surface of the underlying substrate 11. For the thermal sublimation, the major surface of the underlying substrate 11 is subjected to thermal annealing at a temperature of, for example, 1200°C to 2300°C, thereby preparing the underlying substrate 11 having the major surface 11a on which the plane tilted toward the <1-100> direction with respect to the (0001) plane appears regularly in a large region illustrated in Fig. 3, which is preferred.

Remaining steps S20 and S30 are substantially the same as those in the first embodiment. Thus, descriptions thereof are not repeated.

According to this embodiment, step S10 of preparing the underlying substrate 11 includes substep S 12 of planarizing the major surface of the underlying substrate 11. This enables the plane tilted toward the <1-100> direction with respect to the (0001) plane to appear regularly in a large region of the major surface 11a of the underlying substrate 11. Thus, a region of the major surface 11 a in which a plane other than a stable plane is formed can be reduced. This makes it possible to more stably produce the group III-nitride crystal 13 having high quality and a large thickness. It is thus possible to more stably produce the high-quality group III-nitride crystals 10 obtained by cutting the group III-nitride crystal 13.

### (Third Embodiment)

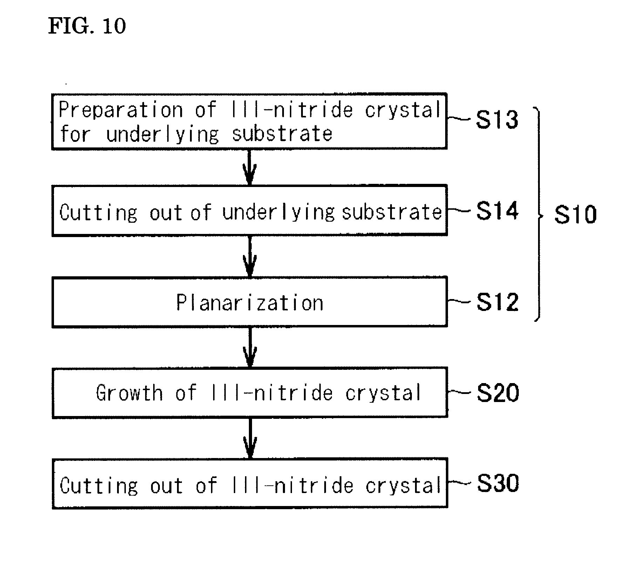

Figure 10 is a flowchart of a method for producing a group III-nitride crystal according to this embodiment. The method for producing a group III-nitride crystal according to this embodiment will be described with reference to Fig. 10.

As illustrated in Fig. 10, the method for producing a group III-nitride crystal according to this embodiment basically includes the same steps as those in the method for producing a group III-nitride crystal according to the first embodiment but is different in that substep S 13 of preparing a group III-nitride crystal for a underlying substrate, the group III-nitride crystal having the (0001) plane that serves as a major surface, and substep S 14 of cutting out a underlying substrate from the group III-nitride crystal for a underlying substrate are included. That is, in this embodiment, the underlying substrate 11 is composed of the group III-nitride crystal.

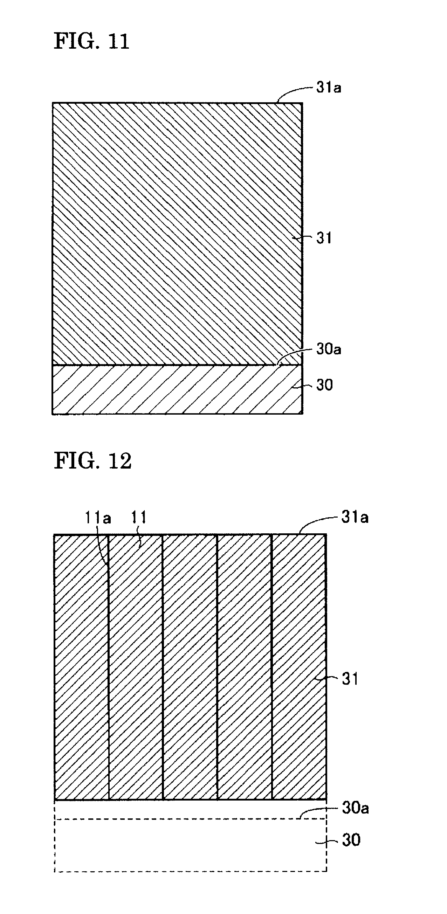

Figure 11 is a schematic cross-sectional view of a state in which a group III-nitride crystal for a underlying substrate according to this embodiment is grown. Referring to Figs. 10 and 11, first, a group III-nitride crystal 31 for a underlying substrate, the group III-nitride crystal 31 having the (0001) plane that serves as a major surface 30a, is prepared (substep S 13).
For example, substep S 13 is performed as follows.

First, a underlying substrate 30 for growing the group III-nitride crystal 31 for a underlying substrate is prepared. The underlying substrate 30 is not particularly limited. A group III-nitride crystal, SiC, sapphire, or the like may be used. Then the group III-nitride crystal 31 is grown on the major surface 30a of the underlying substrate 30. A method for growing the group III-nitride crystal 31 is not particularly limited. For example, vapor-phase epitaxy, such as a sublimation method, HVPE, MBE, and MOCVD, and a liquid-phase method, such as a flux growth method and high nitrogen pressure solution method, may be employed. Thereby, the group III-nitride crystal 31 for a underlying substrate can be prepared.

The group III-nitride crystal 31 for a underlying substrate particularly preferably has a composition ratio the same as that of the group III-nitride crystal 13 to be grown thereon.

Figure 12 is a schematic cross-sectional view of a state in which a underlying substrate according to this embodiment is cut out. Next, as illustrated in Figs. 10 and 12, the underlying substrates 11 are cut out from the group III-nitride crystal 31 for a underlying substrate (substep S14).

In substep S14, the underlying substrates 11 each having the major surface 11a as described above are cut out from the group III-nitride crystal 31 for a underlying substrate. A method of cutting out the underlying substrates is not particularly limited. The group III-nitride crystal 31 for a underlying substrate can be divided by, for example, cutting or cleavage, into the underlying substrates.

In this embodiment, since the major surface 30a of the underlying substrate 30 is the (0001) plane, a major surface 31a, which is the growth face, of the group III-nitride crystal 31 for a underlying substrate is also the (0001) plane. To cut out the underlying substrates 11 having the major surface 11a tilted toward the <1-100> direction with respect to the (0001) plane, the underlying substrates are cut out in a direction intersecting (in Fig. 12, a direction orthogonal to) the major surface 30a of the underlying substrate 30.

The underlying substrates 11 illustrated in Fig. 3 can be prepared by substeps S13 and S 14. After substep S14 of cutting out the underlying substrates 11, substep S12 of planarizing the major surfaces 11a as described above may be performed.

Remaining steps S20 and S30 are substantially the same as those in the first embodiment. Thus, descriptions thereof are not repeated.

As described above, in the method for producing a group III-nitride crystal according to this embodiment, the underlying substrates 11 are composed of the group III-nitride crystal. Thus, the underlying substrate 11 and the group III-nitride crystal 13 to be grown thereon have the same composition or similar compositions. Hence, there is no or only a very small difference in lattice constant between the underlying substrate 11 and the group III-nitride crystal 13 to be grown thereon. This makes it possible to stably produce the group III-nitride crystal 13 having higher quality and a large thickness. It is thus possible to more stably produce the high-quality group III-nitride crystals 10 obtained by cutting the group III-nitride crystal 13.

### EXAMPLES

In these examples, the effect of growing a group III-nitride crystal on a major surface of a underlying substrate, the major surface being tilted toward the <1-100> direction with respect to the (0001) plane, was investigated.

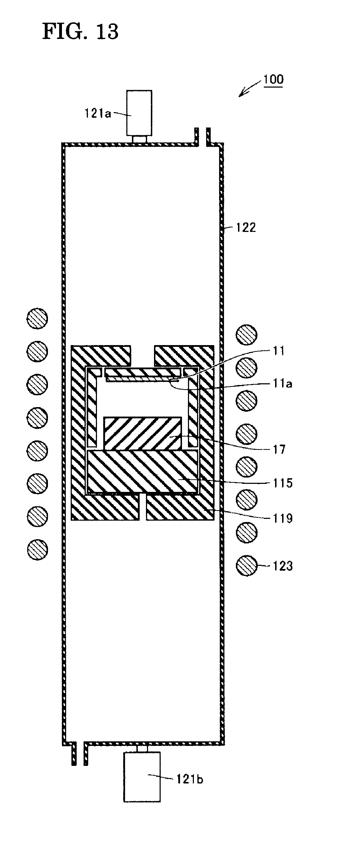

Specifically, an AIN crystal was grown by a sublimation method with a crystal growth apparatus 100 illustrated in Fig. 13. The thickness and quality thereof were investigated. Figure 13 is a schematic view of a crystal growth apparatus used in these examples.

As illustrated in Fig. 13, the crystal growth apparatus 100 mainly includes a crucible 115, a heating member 119, a reactor 122, and a high-frequency induction heating coil 123. The heating member 119 is arranged around the crucible 115 so as to ensure the gas flow between the inside and outside of the crucible 115. The reactor 122 is arranged around the heating member 119. The high-frequency induction heating coil 123 configured to heat the heating member 119 is arranged around the outer central portion of the reactor 122. Pyrometers 121 a and 121 b configured to measure the temperatures of the top and bottom sides of the crucible 115 are arranged at the upper and lower portions of the reactor 122.

The crystal growth apparatus 100 may include various elements other than the foregoing elements. For convenience of explanation, the illustration and explanation of these elements are omitted.

### (EXAMPLE 1)

First, a SiC substrate having the major surface 11a tilted at an angle of 0.5° from the (10-11) plane toward the <1-100> direction was prepared as the underlying substrates 11 (step S10). As illustrated in Fig. 13, the underlying substrate 11 was placed at the upper portion of the crucible 115 in the reactor 122.

Next, an AIN powder was prepared as a raw material for a group III-nitride crystal. The raw material 17 was placed in the bottom of the crucible 115.

Then an AIN crystal serving as the group III-nitride crystal 13 was grown by a sublimation method serving as a vapor-phase epitaxy on a major surface of the underlying substrate (step S20). Specifically, the temperature in the crucible 115 was raised using the high-frequency induction heating coil 123 with nitrogen gas flowed into the reactor 122. The temperature of the underlying substrates 11 was set to 1800°C. The temperature of the raw material 17 was set to 2000°C. The raw material 17 was sublimed and recrystallized on the maj or surface 11a of the underlying substrates 11. The growth time was set to 30 hours. The AIN crystal was grown on the underlying substrates 11.

During the growth of the AIN crystal in step S20, nitrogen gas was continuously flowed into the reactor 122, and the amount of nitrogen gas exhausted from the reactor 122 was controlled in such a manner that the gas partial pressure in the reactor 122 was in the range of about 10 kPa to about 100 kPa.

Steps S10 and S20 described above were performed to form the group III-nitride crystal 13 according to Example 1 on the major surface 11 a of the underlying substrate 11 as illustrated in Fig. 6.

### (EXAMPLE 2)

Example 2 was basically similar to Example 1, except that only step S10 of preparing a underlying substrate was different from that in Example 1.

Specifically, in Example 2, an AIN crystal was produced by the method for producing a group III-nitride crystal according to the third embodiment.

A SiC substrate having the (0001) plane serving as a major surface was prepared as the underlying substrate 30 for a group III-nitride crystal for a underlying substrate. An AIN single crystal was grown as the group III-nitride crystal 31 for a underlying substrate on the SiC substrate so as to have a thickness of 10 mm (substep S13). The underlying substrate 11 was cut out so as to have the (10-11) plane, which was formed on an end face of the AIN single crystal, as the major surface 11a (substep S14). Thereby, the underlying substrate 11 having the (10-11) plane serving as the maj or surface 11a was prepared.

Next, similarly to Example 1, an AlN crystal was grown on the major surface 11a of the underlying substrate 11 (step S20), thereby producing the group III-nitride crystal 13 according to Example 2.

### (EXAMPLE 3)

Example 3 was basically similar to Example 2, except that only step S10 of preparing a underlying substrate was different from that in Example 2. Specifically, the underlying substrate 11 having a plane, which was tilted at an angle of 0.5° from the (10-12) plane toward the <1-100> direction, serving as the major surface 11a was prepared.

Next, similarly to Example 1, an AIN crystal was grown on the major surface 11a of the underlying substrate 11 (step S20), thereby producing the group III-nitride crystal 13 according to Example 3.

### (EXAMPLE 4)

Example 4 was basically similar to Example 2, except that only step S10 of preparing a underlying substrate was different from that in Example 2. S pecifically, the underlying substrate 11 having the (10-12) plane serving as the major surface 11a was prepared.

Next, similarly to Example 1, an AIN crystal was grown on the major surface 11a of the underlying substrate 11 (step S20), thereby producing the group III-nitride crystal 13 according to Example 4.

### (COMPARATIVE EXAMPLE 1)

Comparative Example 1 was basically similar to Example 1, except that only step S 10 of preparing a underlying substrate was different from that in Example 1.

Specifically, a SiC substrate having a major surface tilted at an angle of 3.5° from the (0001) plane toward the <11-20> direction was prepared as a underlying substrate.

Next, similarly to Example 1, an AlN crystal was grown on the major surface of the underlying substrate, thereby producing a group III-nitride crystal according to Comparative Example 1.

### (Evaluation Method)

With respect to the group III-nitride crystals according to Examples 1 to 4 and Comparative Example 1, their appearances were observed, and their thicknesses and dislocation densities were measured.

With respect to the thickness, the smallest thickness of each group III-nitride crystal was measured. That is, the distance between the bottom of the largest recessed portion formed on the surface of the group III-nitride crystal and an interface with the underlying substrate was measured.

The dislocation density was measured as follows. Each group III-nitride crystal was immersed in a melt of a KOH:NaOH (sodium hydroxide) (1:1) mixture in a platinum crucible at 250°C for 30 minutes, thereby etching the group III-nitride crystal. Then each group III-nitride crystal was washed. The number of etch pits formed on the surface per unit area was counted using a microscope. Table 1 shows the results.

**[Table 1]**

| | Major surface of underlying substrate | Thickness | Crystal | Dislocation density |
|---|---|---|---|---|
| Example 1 | Tilted at angle of 0.5° from (10-11) plane toward <1-100> direction | 5mm | Single crystal | 5×10⁵ cm⁻² |
| Example 2 | (10-11) plane | 10mm | Single crystal | 1×10⁵ cm⁻² |
| Example 3 | Tilted at angle of 0.5° from (10-12) plane toward <1-100> direction | 5mm | Single crystal | 5×10⁵ cm⁻² |
| Example 4 | (10-12) plane | 10mm | Single crystal | 1×10⁵ cm⁻² |
| Comparative Example 1 | Tilted at angle of 3.5° from (0001) plane toward <11-20> direction | 4mm | Polycrystal | 1×10⁷ cm⁻² |

### (Evaluation Result)

As shown in Table 1, the growth face of the group III-nitride crystal according to Example 1 using the underlying substrate having the major surface tilted toward the <1-100> direction with respect to the (0001) plane was formed of a uniform plane tilted at an angle of 0.5° from the (10-11) plane toward <1-100> direction. There was no formation of a polycrystal or the like. The group III-nitride crystal had a large thickness of 5 mm. Furthermore, the group III-nitride crystal had a low dislocation density of 5 × 10⁵ cm⁻² or less over the entire surface.

The growth face of the group III-nitride crystal according to Example 2 using the underlying substrate having the major surface tilted toward the <1-100> direction with respect to the (0001) plane was formed of the uniform (10-11) plane. There was no formation of a polycrystal or the like. The group III-nitride crystal had a large thickness of 10 mm. Furthermore, the group III-nitride crystal had a low dislocation density of 1 × 10⁵ cm⁻² over the entire surface.

The growth face of the group III-nitride crystal according to Example 3 using the underlying substrate having the major surface tilted toward the <1-100> direction with respect to the (0001) plane was formed of a uniform plane tilted at an angle of 0.5° from the (10-12) plane toward <1-100> direction. There was no formation of a polycrystal or the like. The group III-nitride crystal had a large thickness of 5 mm. Furthermore, the group III-nitride crystal had a low dislocation density of 5 × 10⁵ cm⁻² over the entire surface.

The growth face of the group III-nitride crystal according to Example 4 using the underlying substrate having the major surface tilted toward the <1-100> direction with respect to the (0001) plane was formed of the uniform (10-12) plane. There was no formation of a polycrystal or the like. The group III-nitride crystal had a large thickness of 10 mm. Furthermore, the group III-nitride crystal had a low dislocation density of 1 × 10⁵ cm⁻² over the entire surface.

In contrast, on the growth face of the group III-nitride crystal according to Comparative Example 1 using the underlying substrate having the major surface that was not tilted toward the <1-100> direction with respect to the (0001) plane, a three-dimensional hillock and large irregularities (bumps) were formed. A polycrystal was formed. The group III-nitride crystal had a small thickness of 4 mm compared with those in Examples 1 to 4. Furthermore, the group III-nitride crystal had a high dislocation density of 1 × 10⁷ cm⁻² in the vicinity of a region where a misorientation occurred, as compared with those in Examples 1 to 4.

The results described above demonstrated that according to these examples, the growth of the group III-nitride crystal on the major surface, which was tilted toward the <1-100> direction with respect to the (0001) plane, of the underlying substrate permits the production of the high-quality group III-nitride crystal with a large thickness.

While the embodiments and examples of the present invention have been described above, appropriately combining the features of the embodiments and examples is also planned from the beginning. It should be understood that the embodiments and examples disclosed herein are illustrative and not limitative in all aspects. The scope of the present invention is shown not by the embodiments above but by the scope of the claims, and is intended to include all modifications within the equivalent meaning and scope of the claims.

### Reference Signs List

10, 13, 31 group III-nitride crystal; 10a, 11a, 13a, 30a, 31a major surface; 11, 30 underlying substrate; 11a region; 11b back surface; 17 raw material; 100 crystal growth apparatus; 115 crucible; 119 heating member; 121a, 121b pyrometer; 122 reactor; 123 high-frequency induction heating coil

## Claims

1. A method for producing a group III-nitride crystal, comprising: a step of preparing a underlying substrate having a major surface tilted toward the <1-100> direction with respect to the (0001) plane; and
a step of growing a group III-nitride crystal on the major surface of the underlying substrate by vapor-phase epitaxy.

2. The method for producing a group III-nitride crystal according to Claim 1, wherein the major surface of the underlying substrate is a plane tilted at an angle of -5° to 5° from the {01-10} plane.

3. The method for producing a group III-nitride crystal according to Claim 1 or 2, wherein in the growth step, the group III-nitride crystal is grown at a temperature of 1600°C or more and less than 1950°C.

4. The method for producing a group III-nitride crystal according to any one of Claims 1 to 3, wherein in the preparation step, a SiC substrate is prepared as the underlying substrate.

5. The method for producing a group III-nitride crystal according to any one of Claims 1 to 3, wherein the preparation step includes
a substep of preparing a group III-nitride crystal for the underlying substrate, the group III-nitride crystal having been grown in such a manner that the (0001) plane serves as a major surface, and
a substep of cutting the group III-nitride crystal for the underlying substrate into the underlying substrate.

6. The method for producing a group III-nitride crystal according to any one of Claims 1 to 5, wherein in the growth step, the group III-nitride crystal is grown so as to have a thickness of 1 mm or more.

7. The method for producing a group III-nitride crystal according to any one of Claims 1 to 6, wherein the preparation step includes a substep of planarizing the major surface of the underlying substrate.

8. The method for producing a group III-nitride crystal according to any one of Claims 1 to 7, further comprising a step of cutting the group III-nitride crystal into a group III-nitride crystal with a nonpolar plane serving as the major surface.

9. A group III-nitride crystal produced by the method for producing a group III-nitride crystal according to any one of Claims 1 to 8, wherein the group III-nitride crystal has a dislocation density of 5 × 10⁶ cm⁻² or less.
